# EUROPÄISCHE PATENTSCHRIFT

(11) **EP 1 067 600 B1**
(45) Veröffentlichungstag und Bekanntmachung des Hinweises auf die Patenterteilung: **02.11.2006**
(21) Anmeldenummer: 00114377.5
(22) Anmeldetag: 05.07.2000
(51) Int. Cl.: H01L 21/8238, H01L 21/84

(54) **CMOS kompatibler SOI-Prozess**
CMOS compatible SOI process
Procédé pour SOI compatible avec technologie CMOS

(30) Priorität: 06.07.1999 DE 19931030; 27.10.1999 EP 99121430
(43) Veröffentlichungstag der Anmeldung: 10.01.2001
(73) Patentinhaber: ELMOS Semiconductor AG, 44227 Dortmund (DE)
(72) Erfinder: Bornefeld, Ralf, Dipl.-Ing., 58579 Schalksmühle (DE)
(74) Vertreter: Hilleringmann, Jochen

(56) Entgegenhaltungen:
- EP-A- 0 570 043
- DE-A- 19 732 237
- US-A- 5 708 287
- PATENT ABSTRACTS OF JAPAN vol. 1998, no. 09, 31. Juli 1998 (1998-07-31) -& JP 10 107288 A (MATSUSHITA ELECTRIC WORKS LTD), 24. April 1998 (1998-04-24)
- PATENT ABSTRACTS OF JAPAN vol. 018, no. 080 (E-1505), 9. Februar 1994 (1994-02-09) -& JP 05 291574 A (FUJITSU LTD), 5. November 1993 (1993-11-05)
- PATENT ABSTRACTS OF JAPAN vol. 1997, no. 03, 31. März 1997 (1997-03-31) -& JP 08 306893 A (NIPPONDENSO CO LTD), 22. November 1996 (1996-11-22)

## Beschreibung

Die Erfindung betrifft ein Verfahren zur Herstellung einer IC-Schaltung mittels eines CMOS-Prozesses, insbesondere HV-CMOS-Prozesses, bei dem Bauelemente innerhalb von unterschiedlich tiefen Wannen von einem ersten Leitungstyp, insbesondere n-Wannen, ausgebildet werden, die in einer Substratschicht von einem dem ersten Leitungstyp entgegengesetzten zweiten Leitungstyp, insbesondere in ein p-Substrat, eingebracht werden.

### Stand der Technik

Seit Anfang der 90er Jahre sind Veröffentlichungen über SOI-Prozesse zu finden, die sich grob in zwei Klassen einteilen lassen: Dick-SOI-Prozesse, in denen die aktive Siliziumschicht in Größenordnungen von deutlich über einem µm Schichtdicke liegt, und Dünn-SOI-Prozesse, die mit wesentlich geringeren aktiver Siliziumschichten von bis zu unter 100 nm operieren.

Während in Dünn-SOI-Prozessen die elektrischen Eigenschaften der Bauelemente sehr stark in ihren Eigenschaften von Standardprozessen abweichen, bieten Dick-SOI-Prozesse grundsätzlich günstigere Voraussetzungen dafür.

Durch die Isolation von Schaltungsteilen und/oder Bauelementen durch z.B. die Verwendung von Trenches, d.h. in die Tiefe der Siliziumschicht eingebrachte Vertikalisolationsschichten zur Lateral-Isolation von Funktionsgebieten eines Chip, auf Dick-SOI-Material ergeben sich erhebliche Vorteile gegenüber Standardtechnologien:
- Parasitäreffekte, wie z.B. Latch-Up werden vollständig unterdrückt.
- In Leistungsschaltern generierte Minoritäten können keine Störungen in benachbarten Schaltungsteilen (z.B. Logik) erzeugen.
- Freie, d.h. vom Substrat entkoppelte, Bauelemente, wie z.B. Dioden, bieten neue Möglichkeiten in der Schaltungsentwicklung.
   JP10107288 veröffentlicht eine IC-Schaltung in einem SOI-Wafersubstrat, wo ein CMOS von einem DMOS durch vertikale Isolationsgebiete getrennt ist.

### Zusammenfassende Darstellung der Erfindung

Grundlegende Idee der Erfindung ist die Entwicklung eines SOI-Prozesses (SOI = Silicon on insulator) mit besonders einfacher Prozessführung, der in hohem Maß kompatibel zu einem Standard-CMOS-Prozess auf Standard-Siliziumsubstraten ist. Die Kompatibilität gilt dabei sowohl für die Prozessführung als auch für das elektrische Verhalten der Bauelemente.

Der SOI-Prozess, bei dem das Substrat eine auf einer Isolationsschicht angeordnete Siliziumschicht aufweist, soll Vorteile der dielektrischen Isolation von Bauelementen und Schaltungsteilen für Smart-Power- und Hochtemperaturanwendungen nutzen.

Wünschenswert ist es, einen an sich bekannten und damit gut beherrschbaren CMOS-Prozess, insbesondere Hochvolt-(HV-)CMOS-Prozess auf einen sogenannten gebondeten Wafer, also einen SOI-Wafer anwenden zu können. Ein gebondeter Wafer weist eine obere Silizium-Schicht auf, in der die Bauelemente integriert sind. Unterhalb dieser Silizium-Schicht ist eine Isolationsschicht aus insbesondere SiO angeordnet, unterhalb derer sich eine Trägerschicht befindet, die vorzugsweise wiederum aus Silizium besteht. Dieser mit der Isolationsschicht versehene Siliziumwafer ist mit der Trägerschicht verbondet.

Mit der Erfindung wird ein Verfahren zur Herstellung einer IC-Schaltung mittels eines CMOS-Prozesses, insbesondere HV-CMOS-Prozesses, vorgeschlagen, bei dem Bauelemente innerhalb von unterschiedlich tiefen Wannen von einem ersten Leitungstyp, insbesondere n-Wannen, ausgebildet werden, die in einer Substratschicht von einem dem ersten Leitungstyp entgegengesetzten zweiten Leitungstyp, insbesondere in ein p-Substrat, eingebracht werden, wobei bei dem Verfahren
- ein SOI-Wafersubstrat verwendet wird, das eine obere Substratschicht zur Ausbildung der CMOS-Bauelemente, eine darunter angeordnete Lateral-Isolationsschicht und eine unter dieser angeordnete Trägerschicht aufweist,
- wobei die obere Substratschicht eine Dicke aufweist, die kleiner als oder gleich der größten Wannentiefe des CMOS-Prozesses ist,
- in die obere Substratschicht bis zur darunterliegenden Lateral-Isolationsschicht Vertikal-Isolationsgebiete eingebracht werden und
- innerhalb der zwischen den Vertikal-Isolationsgebieten liegenden Bereiche der Siliziumschicht mittels des CMOS-Prozesses Bauelemente ausgebildet werden, wobei sich die Wannen mit der größten Tiefe (Hochvolt-n-Wanne) bis zur Isolationsschicht erstrecken, und in diese Wannen größter Tiefe (Hochvolt-n-Wanne) direkt Bauelemente integriert werden können, während für Bauelemente, die eine geringere Wannentiefe benötigen, die diese Bauelemente umgebenden Wannen (Logik-n-Wanne) in Wannen größter Tiefe (Hochvolt-n-Wanne) eingebracht werden.

Die erfindungsgemäß auf dem SOI-Wafersubstrat hergestellten CMOS-Bauteile verhalten sich dann im wesentlichen genau so wie in einem Standardsubstrat ausgebildete CMOS-Bauteile, wenn sich die Verhältnisse im Bereich unterhalb der Bauteile, also in Richtung größerer Tiefen der oberen Substratschicht des SOI-Wafersubstrats nicht wesentlich von den Verhältnissen im Standardsubstrat unterscheiden. Dies gilt zunächst einmal für CMOS-Transistoren, die direkt in die obere Substratschicht des SOI-Wafersubstrats eingebracht werden können, ohne dass es Wannenstrukturen bedarf. Als Beispiel für eine p-dotierte obere SOI-Substratschicht seien hier beispielsweise ein Hochvolt-NMOS- (HV-NMOS-) oder ein Logik-NMOS-Transistor genannt. PMOS-Transistoren dagegen benötigen eine, im vorgenannten Fall, n-dotierte Wanne. Die Tiefe der n-Wanne für einen HV-PMOS- ist dabei größer als für einen Logik-PMOS-Transistor.

Erfindungsgemäß wird die Dicke der oberen Substratschicht des SOI-Wafersubstrats gleich der größeren Wannentiefe des CMOS-Prozesses gewählt. Diese Wanne reicht also direkt bis zur Isolationsschicht des SOI-Wafersubstrats, womit der bei einem Standardsubstrat gegebene PN-Übergang zum Substrat nicht mehr gegeben ist. Die tiefere n-Wanne ist also erfindungsgemäß vollständig im SOI-Wafersubstrat isoliert angeordnet.

Nun kann diese n-Wanne, wie sie zur Realisierung eines HV-PMOS-Transistors in dem SOI-Wafersubstrat verwendet wird, auch dazu genutzt werden, um in ihr die flachere n-Wanne für einen Logik-PMOS-Transistor einzubringen. Auch hier ist die n-Wanne des PMOS-Transistors isoliert, ohne dass es zu einem PN-Übergang in der Tiefe des SOI-Wafersubstrats kommt; denn die die flache n-Wanne für den Logik-PMOS-Transistor umgebende tiefe n-Wanne reicht wiederum bis zur Isolationsschicht des SOI-Wafersubstrats.

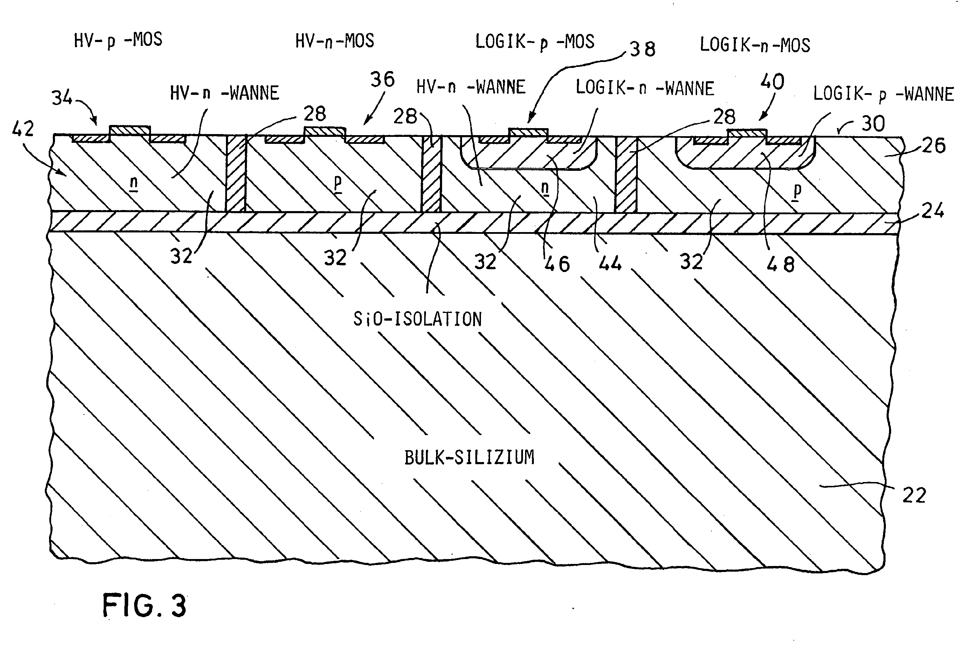

Durch die Abstimmung der Schichtdicke der oberen Substratschicht eines SOI-Wafersubstrats auf die größte Wannentiefe eines CMOS-Prozesses ist es möglich, in dem SOI-Wafersubstrat CMOS-Bauteile zu integrieren, deren Verhalten im wesentlichen dem Verhalten von in einem Standardsubstrat integrierten CMOS-Bauteilen entspricht. Dies geschieht durch die vollständig dielektrische Isolierung von Gebieten unterschiedlichen Leitungstyps. Hierfür ist es insbesondere notwendig, dass die für Komplementärelemente notwendigen Wannen vollständig isoliert sind, um Parasitäreffekte (beispielsweise Bipolar-Effekte) zu vermeiden. Daraus ergibt sich dann die Dicke der oberen Substratschicht, die nicht größer als die Eindringtiefe der Wannen sein darf, um vollständig isolierte Gebiete vom komplementären Leitungstyp erzeugen zu können (siehe Fig. 3). Insbesondere braucht der CMOS-Prozess nicht verändert zu werden, um auf einem SOI-Wafersubstrat angewandt zu werden.

Basierend auf einen Standard-CMOS-Prozess wird also mit der Erfindung die Verwendung von Dick-SOI-Wafersubstraten und Einführung einer VertikalIsolation insbesondere in Form einer Trenchisolation als Pre-Prozess vorgeschlagen. Nach erfolgter Vertikal- also z.B. Trenchisolation wird unverändert der Standard-CMOS-Prozess gefahren.

Der wesentliche Aspekt der Erfindung ist, dass der so entstehende SOI-Prozess sich verfahrenstechnisch nur durch das verwendete Grundmaterial und das Trenchmodul als Vorprozess vom Standard-CMOS-Prozess unterscheidet. Dieser läuft nach erfolgter Trenchisolation unverändert ab und ist voll kompatibel zu dem heute schon auf Standardsubstraten laufenden Prozess. Dies bietet erhebliche Vorteile in der Fertigungslogistik.

Für die Kompatibilität der Bauelemente ist ein ähnlicher Grad an Identität zu erwarten. Dadurch ergibt sich der Vorteil, dass in heutigen Technologien gefertigte Schaltungen einfach in die SOI-Technologie transferiert werden können.

Abschließend bleibt zu sagen, dass das hier vorgeschlagene Verfahren nicht nur bei Standard-CMOS-Prozessen Anwendung finden kann, sondern auf jeden Halbleiter-Herstellungsprozess anwendbar ist.

### Kurzbeschreibung der Figuren

Nachfolgend wird die Erfindung anhand der Zeichnung näher erläutert. Im einzelnen zeigen:
- Fig. 1: ein Ablaufschema des erfindungsgemäßen Herstellungsprozesses mit dem Trenchmodul als Vorstufe für einen Standard-CMOS-Prozess,
- Fig. 2: ein SOI-Wafersubstrat und
- Fig. 3: Beispiele für CMOS-Bauelemente in der aktiven Siliziumschicht des SOI-Wafersubstrats.

### Beschreibung bevorzugter Ausführungsbeispiele

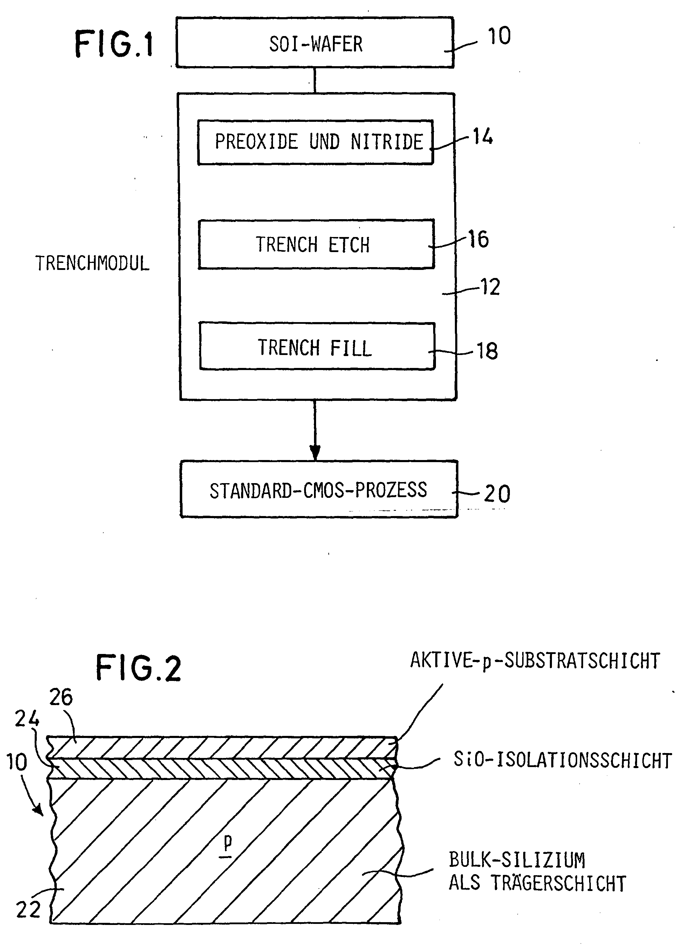

Gemäß Fig. 1 wird ein SOI-Wafer 10 einem Trenchprozess unterzogen, wobei das hierzu verwendete Standard-Trenchmodul 12 den Schritt 14 des Maskierens des SOI-Wafers 10 mittels einer Hardmask, den Schritt 16 des Ätzens von Trenches in die aktive Siliziumschicht des SOI-Wafers 10 und den Schritt 18 des Ausfüllens der Trenches mittels eines Isolationsmaterials (z.B. SiO₂ oder Polysilizium) umfasst. Anschließend läuft zur Ausbildung von Bauelementen in der aktiven Siliziumschicht des SOI-Wafers 10 ein Standard-CMOS-Prozess 20 ab.

Fig. 2 zeigt im Querschnitt den Schichtenaufbau des SOI-Wafers 10 vor dem Trenchprozess und dem Standard-CMOS-Prozess. Der SOI-Wafer 10 weist eine Bulk-Siliziumschicht 22 als Trägerschicht mit einer ausgebildeten Lateral-Isolationsschicht 24 auf. Auf der Lateral-Isolationsschicht 24 befindet sich die aktive p-Siliziumschicht 26, in der die CMOS-Bauelemente ausgebildet werden. Die Laterat-Isolationsschicht 24 dient der Vertikalisolation der aktiven Siliziumschicht 26 gegenüber der Trägerschicht 22.

Die Trägerschicht 22 hat eine Dicke von z.B. ca. 500 µm. Die Lateral-Isolationsschicht 24 ist zwischen 0,5 bis 1,2 µm dick, während die aktive Siliziumschicht 26 eine Dicke im Bereich zwischen 1 und 10 µm aufweist.

Fig. 3 zeigt eine im Maßstab vergrößerte Schnittdarstellung des SOI-Wafers 10 nach erfolgter Trenchisolation und Herstellung von CMOS-Bauelementen. In die aktive Siliziumschicht 26 sind Vertikal-Isolationsgebiete 28 eingebracht, die sich von der Oberseite 30 der aktiven Siliziumschicht 26 aus bis zur Lateral-Isolationsschicht 24 erstrecken und der Isolation einzelner Bereiche 32 der aktiven Siliziumschicht 26 in Lateralerstreckung dienen. Die Lateral-oder Breitenerstreckung der Vertikal-Isolationsgebiete 28 liegt zwischen 0,6 bis 2 µm. In den gegeneinander isolierten Bereichen 32 werden nun mit dem Standard-CMOS-Prozess diverse Bauelemente, wie z.B. ein Hochvolt-p-MOS 34, ein Hochvolt-n-MOS 36, ein Logik-p-MOS 38 und ein Logik-n-MoS 40 ausgebildet. Der Hochvolt-p-MOS 34 ist in eine diffundierte HV-n-Wanne 42 eingebracht, die den gesamten Bereich 32 ausfüllt. Damit ist dieser Bereich 32 vollständig dielektrisch isoliert. Ein p-n-Übergang dieses Bereiches 32 in Richtung auf die diesen begrenzenden Vertikal-Isolationsgebiete 28 und die Lateral-Isolationsschicht 24 existiert also nicht. Auch der Bereich 32, in dem der Logik-p-MOS 38 ausgebildet ist, ist vollständig von einer HV-n-Wanne 44 ausgefüllt, um in dieses Gebiet 32 eine flache Logik-n-Wanne 46 einzubringen, in der sich der Logik-p-MOS 38 befindet. Der Logik-n-MOS 40 befindet sich in einer flachen Logik-p-Wanne 48, die in den isolierten p-Bereich 32 eingebracht ist. Der HV-n-MOS 36 schließlich ist in den isolierten p-Bereich 32 eingebracht.

## Patentansprüche

1. Verfahren zur Herstellung einer IC-Schaltung mittels eines CMOS-Prozesses, insbesondere Hochvolt-CMOS-Prozesses, bei dem Bauelemente innerhalb von unterschiedlich tiefen Wannen von einem ersten Leitungstyp, insbesondere n-Wannen, ausgebildet werden, die in einer Substratschicht von einem dem ersten Leitungstyp entgegengesetzten zweiten Leitungstyp, insbesondere in ein p-Substrat, eingebracht werden, wobei bei dem Verfahren
- ein SOI-Wafersubstrat (10) verwendet wird, das eine obere Substratschicht (26) zur Ausbildung der CMOS-Bauelemente (34-40), eine darunter angeordnete Lateral-Isolationsschicht (24) und eine unter dieser angeordnete Trägerschicht (22) aufweist,
- wobei die obere Substratschicht (26) eine Dicke aufweist, die kleiner als oder gleich der größten Wannentiefe des CMOS-Prozesses ist,
- in die obere Substratschicht (26) bis zur darunterliegenden Lateral-Isolationsschicht (24) Vertikal-Isolationsgebiete (28) eingebracht werden und
- innerhalb der zwischen den Vertikal-Isolationsgebieten (28) liegenden Bereiche (32) der Substratschicht (26) mittels des CMOS-Prozesses Bauelemente (34-40) ausgebildet werden, wobei sich die Wannen (42,44) mit der größten Tiefe (HV-n-Wanne) bis zur Isolationsschicht (24) erstrecken und den jeweiligen Bereich (32) vollständig ausfüllen, und in diese Wannen (42,44) größter Tiefe (HV-n-Wanne) direkt Bauelemente (34,36) integriert werden, während für Bauelemente (38,40), die eine geringere Wannentiefe benötigen, die diese Bauelemente (38,40) umgebenden Wannen (46,48) (Logik-n-Wanne) in Wannen (42,44) größter Tiefe (HV-n-Wanne) eingebracht werden.

2. Verfahren nach Anspruch 1, **dadurch gekennzeichnet, dass** die Vertikal-Isolationsgebiete (28) durch Vertikal-Ätzung eines Trench in die Substratschicht (26) bis zur Lateral-Isolationsschicht (24) und durch anschließendes Einbringen oder Ausbilden eines Isolationsmaterials in dem Trench erzeugt werden.

3. IC-Schaltung mit CMOS-Bauelementen (34-40), die nach Anspruch 1 oder 2 hergestellt sind.

## Claims

1. A method for producing an integrated circuit using a CMOS process, in particular a high voltage CMOS process, wherein components are formed within troughs of different depths and of a first conductivity type, in particular N-type troughs, which are formed in a substrate layer of a second conductivity type opposite to the first conductivity type, in particular a P-type substrate, the method being **characterized in that**
- an SOI wafer substrate (10) is used that comprises a top substrate layer (26) for forming the CMOS components (34-40), a lateral insulation layer (24) provided beneath the substrate layer, and a support layer (22) arranged beneath the insulation layer,
- the top substrate layer (26) has a thickness less than or equal to the greatest trough depth of the CMOS process,
- the top substrate layer (26) is provided with vertical insulation areas (28) down to the subjacent lateral insulation layer (24), and
- components (34-40) are formed within areas (32) of the substrate layer (26) intermediate the vertical insulation areas (28) using the CMOS process, wherein the troughs (42, 44) of the greatest depth (high-voltage N-type trough) extend to the insulation layer (24) and fill the respective area (32) entirely, and wherein components (34, 36) are integrated directly in the troughs (42, 44) of the greatest depth (high-voltage N-type trough), whereas, for components (38, 40) requiring a lesser trough depth, the troughs (46, 48) (logic N-type trough) surrounding these components are provided in troughs (42, 44) of the greatest depth (high-voltage N-type trough).

2. The method of claim 1, wherein the vertical insulation areas (28) are formed by vertically etching a trench into the substrate layer (26) down to the lateral insulation layer (24) and by successively providing or forming an insulating material in the trench.

3. An integrated circuit comprising CMOS components (34-40) produced in accordance with claim 1 or 2.

## Revendications

1. Procédé de fabrication d'un circuit intégré au moyen d'un processus CMOS, en particulier d'un processus CMOS haute tension, dans lequel des composants sont formés à l'intérieur de cuves de différentes profondeurs d'un premier type de conducteur, en particulier de cuves n, qui sont introduites dans une couche de substrat d'un type de conducteur opposé au premier type de conducteur, en particulier dans un substrat p, le procédé dans lequel,
- une galette substrat SOI (10) est utilisée, qui comporte une couche de substrat supérieure (26) pour la formation des composants CMOS (34 - 40), une couche d'isolation latérale (24) disposée en dessous et une couche support (22) disposée en dessous de cette dernière,
- la couche de substrat supérieure (26) présentant une épaisseur qui est plus petite ou égale à la plus grande profondeur de cuve du processus CMOS,
- des zones d'isolation verticale (28) étant insérés dans la couche de substrat supérieure (26) jusqu'à la couche d'isolation latérale (24) disposée en dessous et
- des composants étant formés, à l'intérieur des domaines (32) de la couche de substrat supérieure (26) se trouvant entre les zones d'isolation verticale (28), au moyen du processus CMOS, sachant que les cuves (42, 44) de la profondeur la plus grande (cuve HV-n) s'étendent jusqu'à la couche d'isolation (24) et remplissent complètement le domaine (32) respectif et que, dans ces cuves (42, 44) de profondeur maximale (cuve HV-n), des composants (34, 36) sont intégrés directement, tandis que pour des composants (38, 40) qui ont besoin d'une profondeur de cuve plus faible, les cuves (46, 48) (cuve logique n) qui entourent ces composants (38, 40) sont incorporées dans des cuves (42, 44) de profondeur plus grande (cuve HV-n).

2. Procédé selon la revendication 1, **caractérisé en ce que** les zones d'isolation verticale (28) sont produites par gravure verticale d'une saignée dans la couche de substrat (26) jusqu'à la couche d'isolation latérale (24), suivie de l'introduction ou de la formation d'une couche de matériau isolant dans la saignée.

3. Circuit intégré avec des composants CMOS (34 - 40) qui sont fabriqués selon la revendication 1 ou 2.
